# EUROPEAN PATENT APPLICATION

(11) **EP 1 351 303 A2**
(43) Date of publication of application: **08.10.2003**
(21) Application number: 03075775.1
(22) Date of filing: 17.03.2003
(51) Int. Cl.: H01L 27/00

(54) **Displaying selected images using an organic light-emitting display**

(30) Priority: 28.03.2002 US 108970
(71) Applicant: EASTMAN KODAK COMPANY, Rochester, New York 14650 (US)
(72) Inventor: Brost, Randolph C., Rochester, New York 14650-2201 (US); Strip, David R. c/o EASTMAN KODAK COMPANY, Rochester, New York 14650-2201 (US)
(74) Representative: Weber, Etienne Nicolas

(57) **Abstract**

An organic light emitting display device for displaying selected images from a plurality of images, each with one or more desired colors is described along with method of fabrication. The fabrication of this display device comprises the steps of: providing a first electrode having a first shape; providing an organic emitting layer over the first electrode, wherein the organic emitting layer comprises a plurality of light emitting areas that emit different colored light, which combine to provide at least one desired color; providing a plurality of second electrodes each having a predefined shape over the organic emitting layer, wherein the overlap between the first electrode and each of the second electrodes defines each image area to be displayed; and providing a means for addressing the first electrode and selectively addressing each of the second electrodes.

## Description

The present invention relates to organic light emitting diode (OLED) display devices for displaying predetermined colored images such as icons.

Many consumer and commercial devices include an electronic display to display information. These displays often include predetermined images to indicate battery charge, ring status, and so forth. These images typically communicate information by whether they are on or off, and sometimes by their color. For example, the display on a portable music player might contain a small triangle that is on when music is playing, and off at other times. Battery charge may be indicated by a small picture of a battery, which appears green if the battery is fully charged, yellow if the battery is running low, and red if there is insufficient charge in the battery to perform some operation. In both of these examples, the shape of the image remains fixed.

A device with several functions may include many such images on its display. These images might be displayed in a wide variety of colors, either to make the display more attractive, or because the device functionality requires it. For example, a temperature indicator might be comprised of a series of bars, with blue bars on one end indicating a low temperature, red bars on the other end indicating a high temperature, with a rainbow of bars appearing in between. Another example display might include a company logo, comprised of several different specific colors. It is easy to see that a wide range of devices could utilize displays showing multiple predetermined images, in multiple colors.

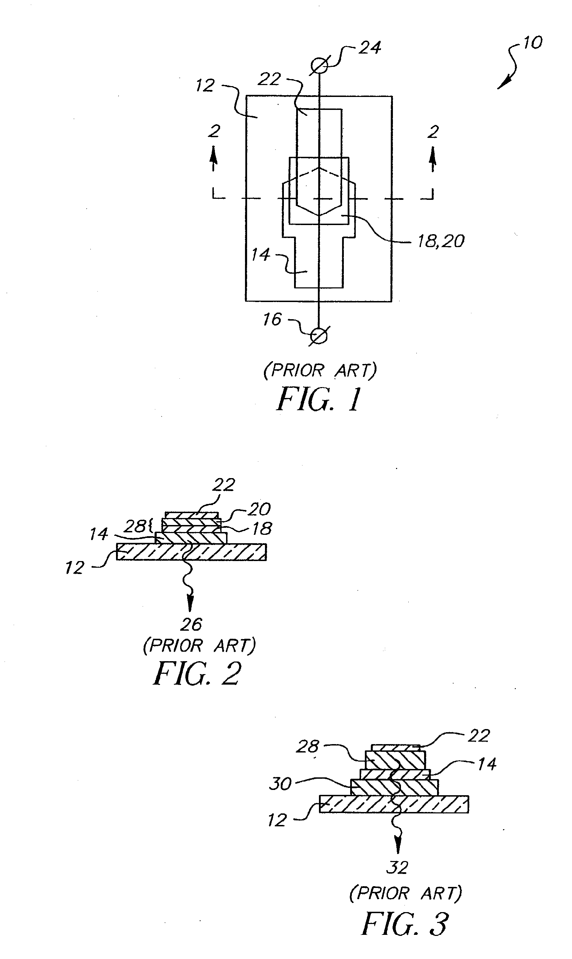

One way of producing such displays would be to use Organic Light-Emitting Diodes (OLEDs). OLEDs offer the advantages of bright illumination, low power consumption, thin profile, and a wide viewing angle. FIGS. 1 and 2 show an example OLED known in the art that displays an image of a hexagon. FIG. 1 shows a top view of the device 10, while FIG. 2 shows a cross-section with material thicknesses shown exaggerated for clarity. The device 10 is built on a substrate 12 made of a transparent material, such as glass. Upon this glass is deposited a thin film of a transparent conductive material, such as indium tin oxide, which forms an anode 14 of the device 10. The anode 14 is connected to a terminal 16. Next there is a layer of a hole-transporting material 18, such as naphthaphenylene benzidene. Above this is a layer of an electron-transporting material 20, such as tris(8-hydroxyquinoline)aluminum(III). A final conductive layer is deposited on top, forming a cathode 22 of the device 10. This cathode 22 is connected to a terminal 24. When a positive voltage is applied from terminal 16 to terminal 24, current flows through the device 10, causing holes and electrons to recombine near the interface between hole-transporting layer 18 and electron-transporting layer 20, emitting light 26. The combination of hole transporting layer 18 and electron-transporting layer 20 are referred to herein as the organic emitting layer 28 of the OLED. Light is emitted throughout the region where the anode 14 and cathode 22 overlap, producing the visual image of a hexagon. This design, and others that are similar, are well-known to those skilled in the art. Red, green, and blue-emitting OLED materials are also well known in the art.

There are several known ways of producing a multi-color, multi-image display using OLEDs known in the art. One method is to use a different emitter material for each desired color. This approach produces a device with the desired functionality, but is complex to manufacture, because it requires as many different emitter materials as there are colors, each of which requires a complex manufacturing step, which must be executed with high precision.

A second method known in the art is to use a single emitter material, and achieve different colors by adding light-altering elements between the emitter and the viewer. This approach is shown in FIG. 3. Light from the organic emitter layer 28 passes through the light-altering element 30, causing light of a different color 32 to emerge. The light-altering element 30 changes the light color either through filtration, fluorescence, or both. This approach has the disadvantage of reduced luminance efficiency. While this approach avoids the need for a different emitter material for each color, it still requires a complex manufacturing process, since different light-altering element materials are required for each desired color.

A third method known in the art is to display the images using a general-purpose array of small picture elements (pixels), where each pixel is individually controlled. Pixels in the array could then be alternately colored with primary colors such as red, green, and blue, and control electronics are then added to drive the pixels with the appropriate current or voltage required to produce the desired color. This approach avoids the requirement for different emitter or light-altering materials for each color, but requires significantly more complex and costly conductor routing, terminal connections, and drive electronics.

Thus, there remains a need to easily create OLED images in a full range of colors.

It is an object of the present invention to provide images of selectable colors while reducing the number of elements needed to produce such colors.

Another object of the present invention to provide an OLED display which effectively can present predetermined colored images such as icons.

It is a further object of the present invention to provide an OLED display for producing colored images which can be fabricated with reduced processing steps.

These objects are achieved in an organic light emitting display device comprising: a first electrode having a first shape; an organic emitting layer provided over the first electrode, wherein the organic emitting layer comprises a plurality of light emitting areas that emit different colored light, which combine to provide at least one desired color; and a second electrode having a second shape and provided over the organic emitting layer, wherein the overlap between the first and second electrodes defines the image area to be displayed.

These objects are further achieved in a method for fabricating an organic light emitting display device for displaying selected images from a plurality of images, each with one or more desired colors, comprising the steps of: providing a first electrode having a first shape; providing an organic emitting layer over the first electrode, wherein the organic emitting layer comprises a plurality of light emitting areas that emit different colored light, which combine to provide at least one desired color; providing a plurality of second electrodes each having a predefined shape over the organic emitting layer, wherein the overlap between the first electrode and each of the second electrodes defines each image area to be displayed; and providing a means for addressing the first electrode and selectively addressing each of the second electrodes.

OLED displays made in accordance with the present invention have the advantage of providing multiple images of arbitrary color, while requiring a reduced number of emitter materials, no light-altering materials, and very simple drive electronics.
FIG. 1 is a plan view of a prior art single OLED display device;
FIG. 2 is a cross-sectional view taken along the lines 2-2 of FIG. 1;
FIG. 3 is a cross-sectional view of a prior art OLED device containing a light-altering element;
FIG. 4 is a plan view of an OLED display in accordance with the present invention showing different images in different positions;
FIG. 5 is a cross-sectional view taken along the lines 5-5 of FIG. 4 showing a particular portion of one of the images;
FIG. 6 shows a plan view of an image that may be displayed in more than one color;
FIG. 7 is a cross-sectional view taken along the lines 7-7 of FIG. 6 showing a particular portion of the image;
FIG. 8 shows a plan view of an image that may be displayed in more than one color; and
FIG. 9 is a cross-sectional view taken along the lines 9-9 of FIG. 8 showing a particular portion of the image.

### Exemplary Embodiment 1

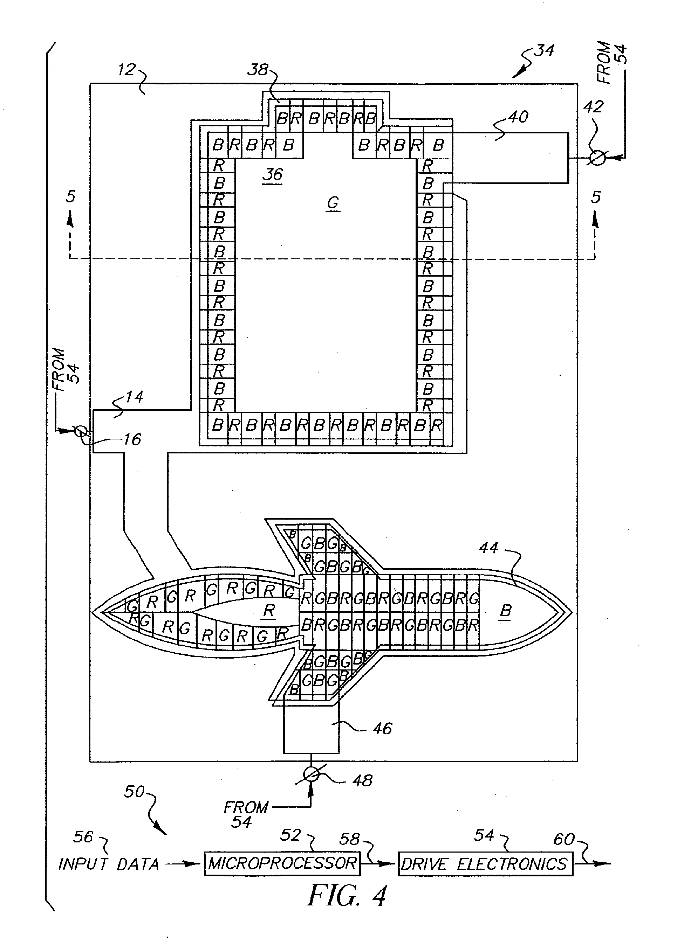

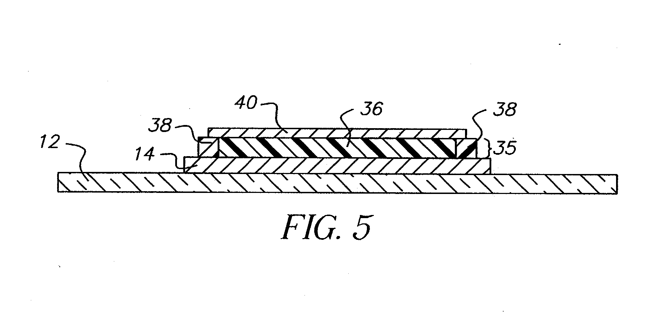

FIG. 4 shows an example embodiment of the invention showing two selectable images, while FIG. 5 shows a cross-section with exaggerated material thickness. The device 34 includes a transparent substrate 12, with a transparent anode 14 patterned onto the substrate 12 and connected to the terminal 16. Over the anode 14 is a patterned organic emitting layer 35, which includes a central region 36 and a surrounding border region 38. In this example, central region 36 contains an organic emitting layer that emits only green light. The organic emitting layer in border region 38 has a plurality of alternating areas that emit red or blue light, with the blue areas twice the size of the red areas. The size of the individual red and blue areas is exaggerated for clarity; typically they would be made small enough so that the unaided human eye would not be able to distinguish individual areas. Thus, the border region 38 would appear to the human observer as the combination of these colors, that is, purple. The patterned emitter areas may be produced by a variety of processes, such as vapor deposition through masks, ink-jet application, laser thermal deposition, and so forth. Over the organic emitting layer 35 is a cathode 40, connected to a terminal 42. The overlap between cathode 40 and anode 14 defines the image area that will be displayed. When a positive voltage is applied from terminal 16 to terminal 42, all of the emitting regions 36 and 38 illuminate, producing the visual image of a green battery surrounded by a purple border. This is accomplished by means of an electronic control system 50 including control logic 52, such as a microprocessor, and drive electronics 54. Given input data 56, the control logic 52 generates control signals 58, which are converted to drive signals 60 by drive electronics 54 that allow a voltage to be applied selectively between terminal 16 and terminal 42.

The device 34 also contains a second selectable image. The anode 14 is also the anode for this image, but the organic emitting layer 44 is now a collection of several regions, each having a plurality of smaller emitting areas containing organic emitting layers that emit red, green, or blue light. Again the size of individual emitting areas is exaggerated for clarity, and typically would be made small enough so that the unaided human eye would not be able to distinguish individual areas and perceive only the combined color. Over this organic emitting layer is a cathode 46, connected to a terminal 48. When the drive electronics 54 selectively applies a positive voltage from terminal 16 to terminal 48, the organic emitting layer 44 illuminates, producing the visual image of a rocket with a white body, blue nose, cyan fins, and an orange exhaust flame with a red core.

This embodiment shows an important advantage of the invention. The device 34 shows two selectable images which include seven colors: green, purple, white, blue, cyan, red, and orange. Yet this device 34 requires only three different emitter materials (red, green, and blue), no light-altering filters or fluorescent materials, and requires only three terminals and simple drive electronics to control. Arbitrary additional colors could be added without requiring new emitter materials, by simply adding light-emitting areas with the desired ratio of red, green and blue emitting materials. Additional selectable images may be added, requiring only one patterned cathode and connected terminal for each new image.

### Exemplary Embodiment 2

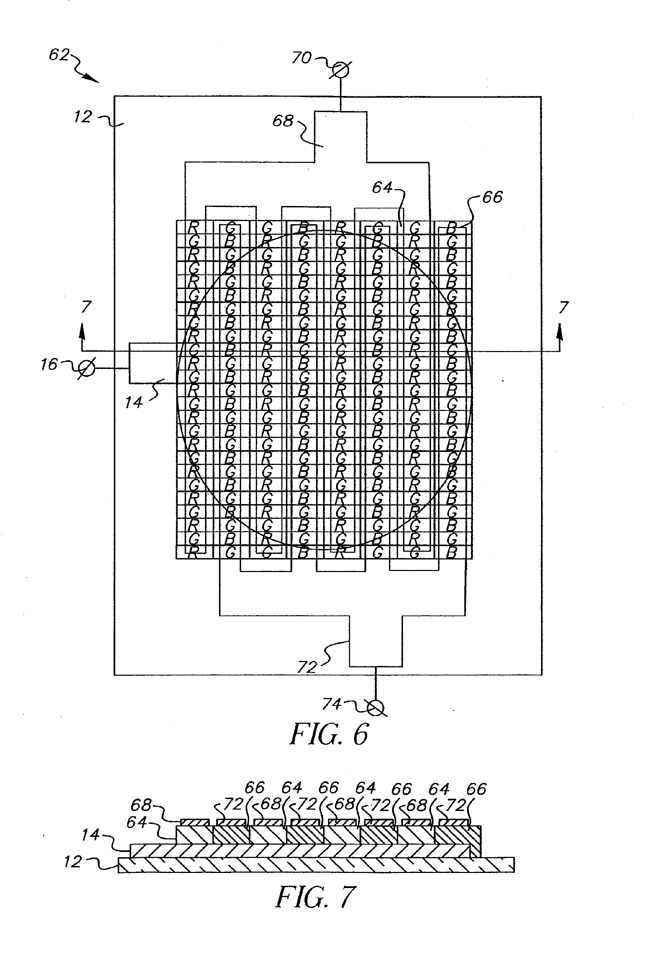

FIG. 6 shows another embodiment of the invention showing one selected image, while FIG. 7 shows a cross-section with exaggerated material thickness. The electronic means for controlling the display and addressing selected images is omitted for clarity. The device 62 includes a transparent substrate 12, with anode 14 patterned onto the substrate 12 and connected to a terminal 16. Provided over the anode 14 is a patterned organic emitting layer including alternating emitting bands 64 and 66. Each emitting band 64 includes a plurality of smaller emitting areas of red or green organic emitter layers, and each emitting band 66 includes a plurality of smaller emitting areas of blue or green organic emitter layers. The size of these individual emitting areas is exaggerated for clarity, and typically would be made small enough so that the unaided human eye would not be able to distinguish individual areas and perceive only the combined color of each emitting band. Thus, emitting band 64 appears yellow and emitting band 66 appears cyan. Patterned in registration over emitting band 64 is a cathode 68, which is connected to a terminal 70. Patterned in registration over emitting band 66 is a cathode 72, connected to a terminal 74. The cathodes 68 and 72 are spaced apart so that each corresponds to a different portion of the image. In this example, these spaced-apart portions are shaped so that each have multiple emitting bands which interdigitate so that both cathodes 68 and 72 overlap the circular anode. In this way, either cathode 68 or 72 may be used in conjunction with the anode 14 to illuminate an area of emitters producing the visual image of a circle. In this example, the interdigitated array includes parallel linear bands. However, this invention is not limited to this, and any shape or pattern of interdigitation may be used, such as interleaved waves or nested spirals.

The device 62 could be, for example, a burner indicator for an electrical stove. Applying a positive voltage from terminal 16 to terminal 70 would illuminate the circle in yellow, indicating that the burner is hot, while applying a positive voltage from terminal 16 to 74 would illuminate the circle in cyan, indicating that the burner is cool. The circle may be illuminated with any color in a continuous range between cyan and yellow by either applying different voltages to terminals 70 and 74 simultaneously, or by applying a voltage to each terminal separately in pulses and adjusting the relative length of each pulse. Alternatively, one set of emitting bands could be a single color, for example, emitting band 66 could be blue. In this way, the circle can be illuminated with any color in a continuous range from blue to yellow, including white.

This example shows how the invention could be used to easily produce a selectable image that can be selectively displayed in either of two arbitrary colors or in a range of colors varying between two arbitrary colors, without requiring a special emitter material for each color. For example, the device 62 could be combined with the device 34 to produce a new device that provides three selectable images with the additional color yellow and the ability to display the circle image in a range of colors, while still only requiring red, green, and blue emitter materials and no light-altering elements. The resulting device would have only four terminals, and would be simple to control.

### Exemplary Embodiment 3

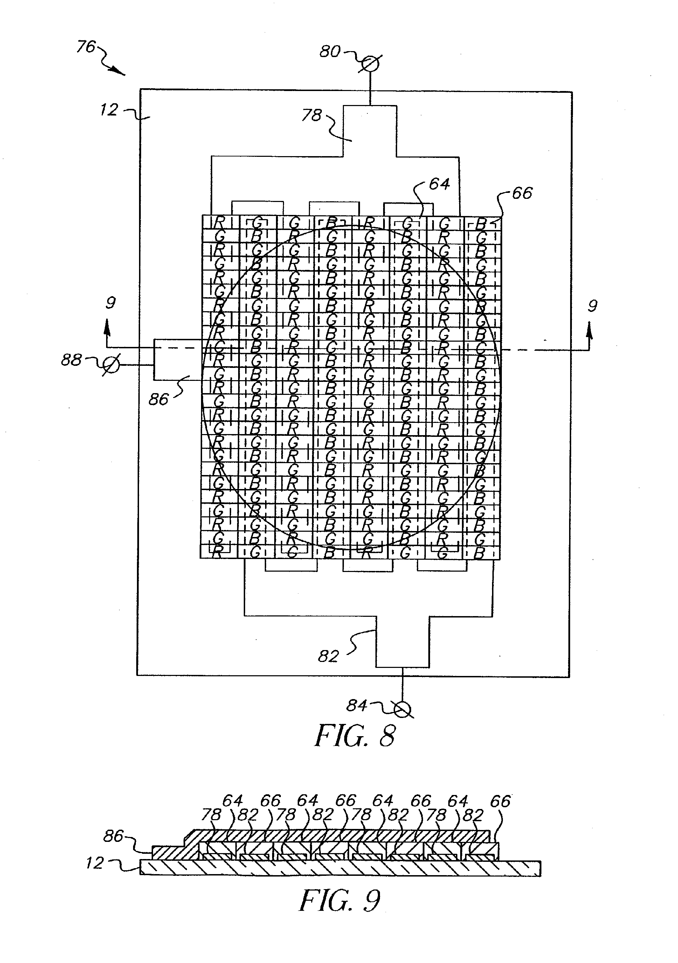

FIG. 8 shows another embodiment of the invention showing one selected image, while FIG. 9 shows a cross-section with exaggerated material thickness. The electronic means for controlling the display and addressing selected images is omitted for clarity. The device 76 includes substrate 12, with two transparent anodes 78 and 82 patterned onto the substrate 12 and connected to terminals 80 and 84, respectively. Provided over these anodes 78 and 82 is a patterned organic emitting layer including alternating emitting bands 64 and 66. As in exemplary embodiment 2, each emitting band 64 includes a plurality of smaller emitting areas of red or green organic emitter layers, and each emitting band 66 includes a plurality of smaller emitting areas of blue or green organic emitter layers. Patterned over emitting bands 64 and 66 is a circular cathode 86, which is connected to a terminal 88. The anodes 78 and 82 are spaced apart so that each corresponds to a different portion of the image. In this example, these spaced-apart portions are shaped so that each have multiple emitting bands which interdigitate so that both anodes 78 and 82 overlap the circular cathode 86. In this way, either anode 78 or 82 may be used in conjunction with the cathode 86 to illuminate an area of emitters producing the visual image of a circle. In this example, the interdigitated array includes parallel linear bands. However, this invention is not limited to this, and any shape or pattern of interdigitation may be used, such as interleaved waves or nested spirals.

Applying a positive voltage from terminal 80 to terminal 88 would illuminate the circle in yellow, indicating that the burner is hot, while applying a positive voltage from terminal 84 to 88 would illuminate the circle in cyan, indicating that the burner is cool. The circle may be illuminated with any color in a continuous range between cyan and yellow by either applying different voltages to terminals 80 and 84 simultaneously, or by applying a voltage to each terminal separately in pulses and adjusting the relative length of each pulse. Alternatively, one set of emitting bands could be a single color, for example, emitting band 66 could be blue. In this way, the circle can be illuminated with any color in a continuous range from blue to yellow, including white.

The invention has been described in detail with particular reference to certain examples, but it will be understood that variations and modifications can be effected within the spirit and scope of the invention. For example, the designs described above employ red, green, and blue emitting materials, but any choices of emitter colors may be used within the spirit of the invention. The designs listed above describe a transparent anode on the substrate, followed by an organic emitter layer and an uppermost cathode. However, the cathode may instead be deposited on the substrate and the anode over the organic emitting layer. Thus, this invention can be described generically using the terms first electrode and second electrode, where the first electrode is provided on the substrate and the second electrode is provided over the organic emitting layer. The image area is still defined by the overlap between the first electrode with a first shape and the second electrode having a second shape. There may be a plurality of second electrodes yielding images of different color, different shapes, or both. The plurality of second electrodes can be interdigitated and provided in registration with a patterned organic emitting layer to provide images with different colors. The shape of the images to a viewer may appear the same or different, depending upon the application. It should also be appreciated that there may be a plurality of first electrodes and a common second electrode, and the invention will operate in the same manner as described above for a plurality of second electrodes and a common first electrode.

The shape of the first electrode may be produced by patterned deposition of conductive material, for example, through a mask. Alternatively, a uniform layer of the first electrode conductive material may be applied and the pattern can be achieved by patterned etching using well-known photolithographic methods. Alternatively, a patterned insulating layer such as photosensitive polyimide may be permanently imaged onto the uniformly deposited first electrode thereby exposing only the desired conductive areas for device fabrication. Patterning of the second electrode may likewise be done through a variety of methods, such as deposition through a shadow mask, or by employing an integral shadow mask as described in US-A-5,276,380

This invention may be used in conjunction with a light diffusing layer to aid the mixing of colors as desired. This invention may also employ a polarizer, an antireflection layer, or an antiglare overcoat.

## Claims

1. An organic light emitting display device for displaying an image, comprising:
(a) a first electrode having a first shape;
(b) an organic emitting layer provided over the first electrode, wherein the organic emitting layer comprises a plurality of light emitting areas that emit different colored light, which combine to provide at least one desired color; and
(c) a second electrode having a second shape and provided over the organic emitting layer, wherein the overlap between the first and second electrodes defines the image area to be displayed.

2. An organic light emitting display device for displaying selected images from a plurality of images, comprising:
(a) a first electrode having a first shape;
(b) an organic emitting layer provided over the first electrode, wherein the organic emitting layer comprises a plurality of light emitting areas that emit different colored light, which combine to provide at least one desired color;
(c) a plurality of second electrodes each having a predefined shape and provided over the organic emitting layer, wherein the overlap between the first electrode and each of the second electrodes defines each image area to be displayed; and
(d) means for addressing the first electrode and selectively addressing each of the second electrodes.

3. The organic light emitting display device of claim 2 wherein the organic emitting layer comprises a plurality of emitting bands, at least one band comprises a plurality of light emitting areas that emit different colored light, which combine to provide a band of a desired color, and wherein at least one band produces light of a different color than the other bands; and
wherein the plurality of second electrodes are interdigitated and provided in registration over the plurality of bands such that selection of one second electrode yields an image that is different in color from that of another second electrode.

4. A method for fabricating an organic light emitting display device for displaying selected images from a plurality of images, each with one or more desired colors, comprising the steps of:
(a) providing a first electrode having a first shape;
(b) providing an organic emitting layer over the first electrode, wherein the organic emitting layer comprises a plurality of light emitting areas that emit different colored light, which combine to provide at least one desired color;
(c) providing a plurality of second electrodes each having a predefined shape over the organic emitting layer, wherein the overlap between the first electrode and each of the second electrodes defines each image area to be displayed; and
(d) providing a means for addressing the first electrode and selectively addressing each of the second electrodes.

5. The method of claim 4 wherein the organic emitting layer comprises a plurality of emitting bands, wherein at least one band comprises a plurality of light emitting areas that emit different colored light, which combine to provide a desired color, and wherein at least one band produces light of a different color than the other bands; and
wherein the plurality of second electrodes are interdigitated and provided in registration over the plurality of bands such that selection of one second electrode yields an image that is different in color from that of another second electrode.

6. The method of claim 5 wherein the shape of each image is the same or a different image.

7. An organic light emitting display device for displaying selected images from a plurality of images, comprising:
(a) a plurality of first electrodes each having a predefined shape;
(b) an organic emitting layer provided over the first electrodes, wherein the organic emitting layer comprises a plurality of light emitting areas that emit different colored light, which combine to provide at least one desired color;
(c) a second electrode having a second shape and provided over the organic emitting layer, wherein the overlap between each of the first electrodes and the common second electrode defines each image area to be displayed; and
(d) means for addressing the second electrode and selectively addressing each of the first electrodes.

8. The organic light emitting display device of claim 7
wherein the organic emitting layer comprises a plurality of emitting bands, at least one band comprises a plurality of light emitting areas that emit different colored light, which combine to provide a band of a desired color, and wherein at least one band produces light of a different color than the other bands; and
wherein the plurality of first electrodes are interdigitated and provided in registration beneath the plurality of emitting bands such that selection of one first electrode yields an image that is different in color from that of another first electrode.

9. A method for fabricating an organic light emitting display device for displaying selected images from a plurality of images, each with one or more desired colors, comprising the steps of:
(a) providing a plurality of first electrodes each having a predefined shape;
(b) providing an organic emitting layer over the first electrodes, wherein the organic emitting layer comprises a plurality of light emitting areas that emit different colored light, which combine to provide at least one desired color;
(c) providing a common second electrode having a second shape over the organic emitting layer, wherein the overlap between each of the first electrodes and the second electrode defines each image area to be displayed; and
(d) providing means for addressing the second electrode and selectively addressing each of the first electrodes.

10. The method of claim 9 wherein the organic emitting layer comprises a plurality of emitting bands, wherein at least one band comprises a plurality of light emitting areas that emit different colored light, which combine to provide a desired color, and wherein at least one band produces light of a different color than the other bands; and
wherein the plurality of first electrodes are interdigitated and provided in registration beneath the plurality of bands such that selection of one first electrode yields an image that is different in color from that of another first electrode.
